# EUROPEAN PATENT APPLICATION

(11) **EP 2 471 980 A1**
(43) Date of publication of application: **04.07.2012**
(21) Application number: 11194298.3
(22) Date of filing: 19.12.2011
(51) Int. Cl.: C30B 29/06, C30B 15/02

(54) **Method for producing silicon single crystal ingot**

(30) Priority: 28.12.2010 JP 2010293964
(71) Applicant: Siltronic AG, 81737 München (DE)
(72) Inventor: Kato, Hideo, Hikari, Yamaguchi 743-0007 (JP); Murakami, Hideaki, Hikari, Yamaguchi 743-0031 (JP)
(74) Representative: Staudacher, Wolfgang

(57) **Abstract**

It is the object of the invention to provide an ingot producing method, which makes it possible to greatly restrict formation of pinholes and substantially prevent them.

In a step of filling polycrystalline silicon of CZ method, small-sized polycrystalline silicon chunks S1 are not used as supplied polycrystalline silicon chunks S, only middle-sized polycrystalline silicon chunks S2 and large-sized polycrystalline silicon chunks S3 are used. Further, in the step of filling polycrystalline silicon, the polycrystalline silicon chunks S are randomly supplied into the crucible 1.

## Description

The present invention relates to a method for producing a silicon single crystal ingot (herein after referred to as "ingot") using the Czochralski method (hereinafter referred to as "CZ method"), and, particularly, to a method for filling a crucible with raw material polycrystalline silicon.

A semiconductor substrate used for producing a semiconductor element is made of a single crystal silicon wafer, and the CZ method is widely used for growing ingots. According to the CZ method, a crucible is filled with polycrystalline silicon, and this polycrystalline silicon is melted to obtain silicon melt. Next, a seed crystal is brought into contact with this silicon melt and an ingot is grown by pulling up the seed crystal. In this process, bubbles contained in the silicon melt do not go out from the surface of the silicon melt and remain in the silicon melt. Then, the bubbles may be taken up by the ingot. Due to this, pinholes which are cavities based upon the bubbles, are formed in the grown ingot.

A silicon wafer is produced by slicing the ingot, and there is the problem that a semiconductor element having the desired configuration cannot be produced from a wafer in which pinholes have been formed.

In order to reduce the formation of pinholes during the growing an ingot, various methods have been conventionally proposed. For example, a method of melting polycrystalline silicon material with a furnace pressure of 5 - 60 mbar to reduce generation of pinholes has been disclosed (see e.g. Japanese Patent Application Publication (Kokai) No. H5-9097). There has been also disclosed a method in which chunks of polycrystalline silicon material are divided into three classes depending on their sizes, the large chunks are arranged along the side surface of a crucible, the small chunks are arranged at the center of the crucible, and the medium chunks are arranged on these small chunks to reduce generation of pinholes (see e.g. Japanese Patent Application Publication (Kokai) No. 2002-535223). Further, there has been disclosed a method in which oscillation is given to a crucible axis supporting the crucible between the step of melting polycrystalline silicon to form a silicon melt and the step of growing an ingot by bringing a seed crystal into contact with the silicon melt, thereby to reduce generation of pinholes (see e.g. Japanese Patent Application Publication (Kokai) No. 2007-210803).

Recently, semiconductor devices have become finer and their thickness has become thinner and, at the time of manufacturing a semiconductor device, pinholes formed in an ingot have caused a more serious problem. Further, many labor hours are required for inspecting the pinholes. For these reasons, the pinholes need to be further reduced, but the above conventional methods have been insufficient.

The object of the present invention is to provide an ingot producing method, which makes it possible to greatly restrict the formation of pinholes and substantially prevent it.

For achieving the above object, the inventor of the present invention has intensively searched for an ingot producing method which makes it possible to greatly restrict formation of pinholes and substantially prevent it. As a result, the inventor has gained the following knowledge.

Namely, the inventor of the present invention assumed that the cause of generation of pinholes lay in small bubbles of at most 1 mm remaining in the silicon melt. Concretely, bigger bubbles have large buoyancy, rise up to the surface of silicon melt, and are immediately gone. However, since small bubbles have small buoyancy and are caught by the flow of the silicon melt, the bubbles remain in the melt and these residual bubbles are taken up in the crystal while the ingot is grown. Namely, the inventor assumed that the cause lies in: In the process of melting the polycrystalline silicon raw materials, the small bubbles remain in the silicon melt, because the bubbles are formed on the surface of the polycrystalline silicon raw materials during the process of melting, the melting of the polycrystalline silicon proceeds with these bubbles adhering to the surface of the polycrystalline silicon, and these bubbles are taken up in the flow of the convective silicon melt. On the basis of this assumption of the cause, the inventor of the present invention has found out that the ratio of the surface area to the weight of the chunks of polycrystalline silicon filled in the crucible, i.e. the ratio of the total surface area to the total weight of the chunks of polycrystalline silicon, is reduced, whereby the generation of the pinholes can be drastically restricted and can be substantially prevented in the grown ingot. The present invention was realized in this manner.

Namely, in order to achieve the above object, the method for producing an ingot according to the present invention comprises a filling step of filling a crucible with polycrystalline silicon, a melting step of melting the filled polycrystalline silicon to form a silicon melt in the crucible, and a pulling up step of bringing a seed crystal into contact with the silicon melt and pulling up the seed crystal brought into contact, to thereby grow an ingot, wherein, in the filling step, the crucible is filled with the polycrystalline silicon by a plurality of chunks of polycrystalline silicon being randomly supplied to the crucible, and the chunks of polycrystalline silicon are large-sized chunks of polycrystalline silicon.

According to the method for producing an ingot according to the present invention, the large-sized chunks of polycrystalline silicon consist of chunks of polycrystalline silicon with a size of at least 20 mm, and the large-sized chunks of polycrystalline silicon include chunks of polycrystalline silicon of at least one of the types of chunks of polycrystalline silicon with a size of more than 50 mm and chunks of polycrystalline silicon with a size of 20 mm to 50mm.

According to the method for producing an ingot according to the present invention, the supplied chunks of polycrystalline silicon include at least the chunks of polycrystalline silicon with a size of more than 50 mm.

According to the method for manufacturing an ingot according to the present invention, the supplied chunks of polycrystalline silicon include at least the chunks of polycrystalline silicon with a size of 20 mm to 50 mm.

According to the method for producing an ingot according to the present invention, the large-sized chunks of polycrystalline silicon consist of the chunks of polycrystalline silicon with a size of more than 50 mm and the chunks of polycrystalline silicon with a size of 20 mm to 50 mm, and the concentration of the chunks of polycrystalline silicon with a size of more than 50 mm is 70 % by weight, while the concentration of the chunks of polycrystalline silicon with a size of 20 mm to 50 mm is 30 % by weight.

According to the method for producing an ingot according to the present invention, in the filling step of filling a crucible with polycrystalline silicon, since large-sized chunks of polycrystalline silicon are supplied to the crucible, it is possible to reduce the ratio of the surface area to the weight of the polycrystalline silicon to be filled, and to greatly restrict the adherence of the bubbles to the polycrystalline silicon when the filled polycrystalline silicon is melted, in comparison with the prior art. Thus, it is possible to greatly restrict the following problem in comparison with the prior art: The bubbles are taken up into silicon melt and the bubbles reside in the silicon melt. Accordingly, it is possible to greatly restrict formation of the pinholes in the grown ingot in comparison with the prior art and to substantially prevent them.

In this manner, in the filling step of filling the crucible with the polycrystalline silicon, irrespective of arrangement of the chunks of polycrystalline silicon in the crucible as in the prior art, the chunks of polycrystalline silicon can be randomly supplied to the crucible. As a result, the filling step can be made simple and trouble-saving.
Fig. 1 is a view showing a conventional method for filling a crucible with polycrystalline silicon in the CZ method.
Fig. 2 is a view showing a method for filling a crucible with polycrystalline silicon in a method for producing an ingot according to an embodiment of the present invention.
Fig. 3 is a view showing kinds of polycrystalline silicon chunks as raw materials.
Fig. 4 is a view showing a graph showing a relative ratio of rates of generation of pinholes between Embodiments 1, 2 according to the present invention and Comparative Example 1.

The present invention will be described in detail below with reference to the drawings showing preferred embodiments thereof.

According to the CZ method, a crucible is filled with polycrystalline silicon as raw materials. Then, in an atmosphere of inert gas, e.g. Ar gas, the polycrystalline silicon filled in the crucible is melted to form a silicon melt, a seed crystal is brought into contact with this silicon melt, and the seed crystal brought into contact with the silicon melt is pulled up, so that an ingot is grown.

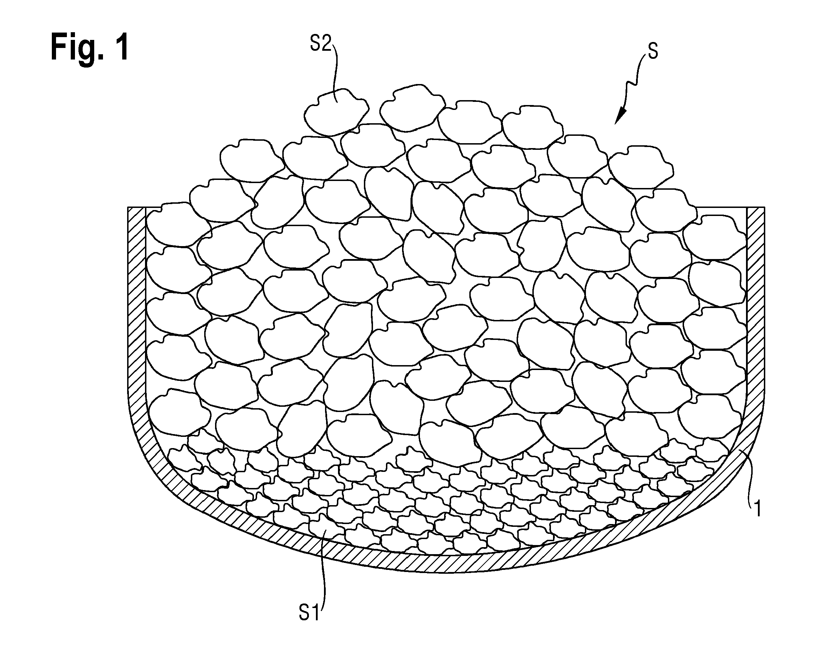

Fig. 1 is a view showing a conventional method for filling a crucible with polycrystalline silicon as a raw material in the polycrystalline silicon filling step of the CZ method. As shown in Fig. 1, a crucible 1 is filled with a plurality of polycrystalline silicon chunks S which are the chunks of polycrystalline silicon used in the conventional method. The polycrystalline silicon chunks include small-sized polycrystalline silicon chunks S1 having a small chunk size and middle-sized polycrystalline silicon chunks S2 having a middle chunk size. The small-sized polycrystalline silicon chunks S1 and the middle-sized polycrystalline silicon chunks S2 are polycrystalline silicon chunks of the size included in the polycrystalline silicon chunks S, which have been generally used in the CZ method.

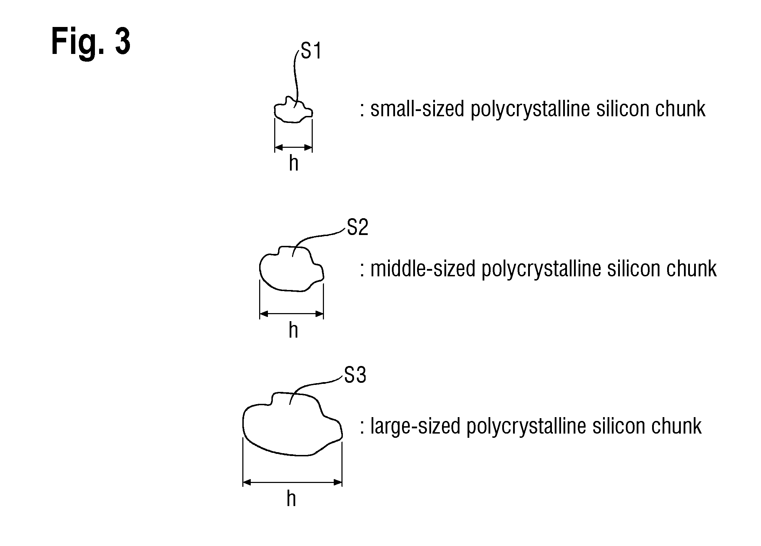

As shown in Fig. 3, the size of the polycrystalline silicon chunks S is defined on the basis of its maximum width h. The small-sized polycrystalline silicon chunks S1 are polycrystalline silicon chunks having the maximum width h of less than 20 mm, and the middle-sized polycrystalline silicon chunks S2 are polycrystalline silicon chunks having the maximum width h from 20 mm to 50 mm.

As shown in Fig. 1, in the conventional method for filling polycrystalline silicon, because of their size, the small-sized polycrystalline silicon chunks S1 are deposited in the lower portion of the crucible 1, and the middle-sized polycrystalline silicon chunks S2 are deposited on these small-sized polycrystalline silicon chunks S1. From the viewpoint of cost reduction due to an increase in ingot size, a high rate of filling a crucible with polycrystalline silicon chunks is required. In conventional methods for filling polycrystalline silicon, polycrystalline silicon chunks of a large size have never been actively filled.

The crucible 1 is, for example, a quartz crucible made of quartz and provided in a furnace which is not shown in the drawing. The crucible 1 filled with the polycrystalline silicon chunks S is exposed to an inert gas atmosphere, e.g. an Ar (argon) gas atmosphere.

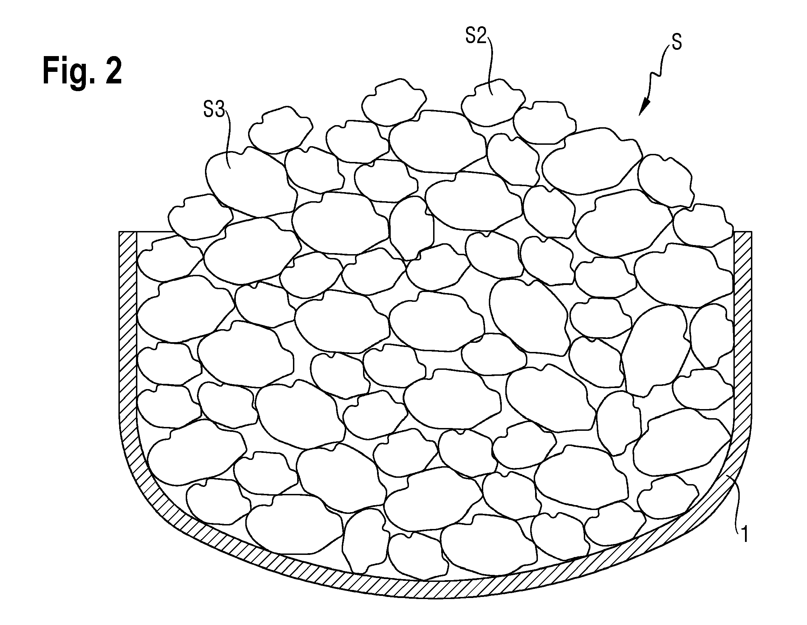

Fig. 2 is a view showing a method for filling a crucible with polycrystalline silicon in a method for producing an ingot according to an embodiment of the present invention.

As shown in Fig. 2, in the method for filling polycrystalline silicon in the present embodiment in the step of filling polycrystalline silicon of the CZ method, the small-sized polycrystalline silicon chunks S1 are not used as the supplied polycrystalline silicon chunks S. Only the middle-sized polycrystalline silicon chunks S2 and large-sized polycrystalline silicon chunks S3 are used. As shown in Fig. 3, the large-sized polycrystalline silicon chunks S3 are the polycrystalline silicon chunks having the maximum width h of more than 50 mm.

In the step of filling polycrystalline silicon in the present embodiment, the polycrystalline silicon chunks S are randomly supplied into the crucible 1. Namely, without considering the arrangement of the polycrystalline silicon chunks S as well as the arrangement and distribution, etc. of the middle-sized polycrystalline silicon chunks S2 and the large-sized polycrystalline silicon chunks S3, the polycrystalline silicon chunks S are supplied into the crucible 1. For example, by inclining a container, in which the polycrystalline silicon chunks S are randomly deposited, the polycrystalline silicon chunks S are randomly supplied into the crucible 1.

As shown in Fig. 2, in the method for filling the polycrystalline silicon chunks S in the present embodiment, the size of the polycrystalline silicon chunks S to be filled is larger than in the case of the conventional method for filling the polycrystalline silicon chunks S show in Fig. 1. For this reason, in the filling method in the present embodiment, the ratio of the total surface area of the polycrystalline silicon chunks S to be filled to the total weight of the polycrystalline silicon chunks S to be filled, can be made smaller than in the case of the conventional filling method in Fig. 1. Therefore, as described above, it is possible to drastically restrict and substantially prevent formation of pinholes in an ingot to be grown in comparison with the prior art.

In the method for producing an ingot according to the present embodiment, the polycrystalline silicon chunks S filled in the crucible 1 consist of the large-sized polycrystalline silicon chunks S3 and the middle-sized polycrystalline silicon chunks S2. However, the polycrystalline silicon chunks S are not limited to the above. The polycrystalline silicon chunks S just have to consist of polycrystalline silicon chunks of at least the size of the middle-sized polycrystalline silicon chunks S2. Further, as described above, it is preferable that the polycrystalline silicon chunks S to be filled have a large size, and it is preferable that, in the polycrystalline silicon chunks S to be filled in the crucible 1, the ratio of the large-sized polycrystalline silicon chunks S3 to the middle-sized polycrystalline silicon chunks S2 is high. However, the maximum size of the large-sized polycrystalline silicon chunks S3 is a size at which the chunks still can be filled into the crucible.

### Examples

Examples of the present invention will be explained below.

By using the method for producing an ingot according to the present embodiment, ingots were grown from two kinds of polycrystalline silicon chunks S as the raw materials (Examples 1 and 2) .

In Example 1, the following polycrystalline silicon chunks S were used as the raw materials: The content ratio (weight distribution) of the middle-sized polycrystalline silicon chunks S2 and the large-sized polycrystalline silicon chunks S3 was the middle-sized polycrystalline silicon chunks S2: 100 % by weight and the large-sized polycrystalline silicon chunks S3: 0 % by weight.

In Example 2, the following polycrystalline silicon chunks S were used as the raw materials: The content ratio of the middle-sized polycrystalline silicon chunks S2 and the large-sized polycrystalline silicon chunks S3 was the middle-sized polycrystalline silicon chunks S2: 30 % by weight and the large-sized polycrystalline silicon chunks S3: 70 % by weight.

As a comparative example, by using the conventional method for filling polycrystalline silicon shown in Fig. 1, an ingot was produced (Comparative Example 1). In Comparative Example 1, the following polycrystalline silicon chunks S were used as the raw materials: The content ratio of the small-sized polycrystalline silicon chunks S1 and the middle-sized polycrystalline silicon chunks S2 was the small-sized polycrystalline silicon chunks S1: 30 % by weight and the middle-sized polycrystalline silicon chunks S2: 70 % by weight.

In above Examples 1, 2 and Comparative Example 1, the total weights of the polycrystalline silicon chunks S as the raw materials were identical with each other and amounted to 130 kg. Further under the same production conditions, the ingot were grown by the CZ method. Incidentally, in the quartz crucible, bubbles mixed during production of the quartz crucible are included, then, in growing an ingot, the bubbles may be emitted from the quartz crucible into silicon melt. Therefore, this can cause generation of pinholes. In the present examples and in Comparative Example 1, the quartz crucibles all having the same quality levels were used, and therefore it can be considered that the difference in the quartz crucibles makes no difference to the rates of generation of pinholes.

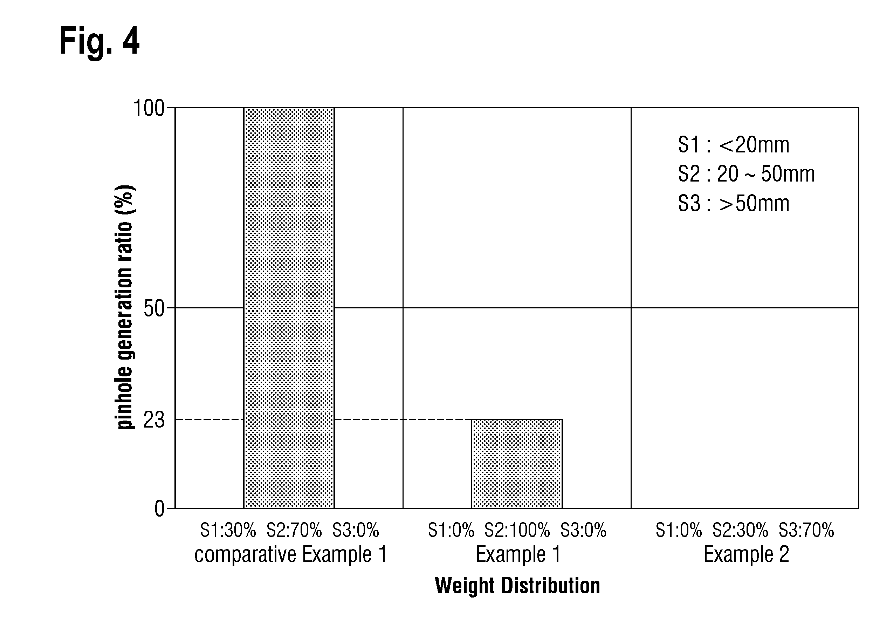

Ten ingots having the length of about 1500 mm grown in Examples 1, 2 and Comparative Example 1 were sliced to produce silicon wafers. For each silicon wafer produced in accordance with Examples 1, 2 and Comparative Example 1, a pinhole test was conducted. The pinhole test was a total amount test by visual observation. The test result is shown in Fig. 4.

Fig. 4 shows a relative ratio of generation rates of pinholes with respect to Comparative Example 1. As show in Fig. 4, in Example 1, it can be seen that the generation of pinholes can be restricted by 77% in comparison with the Comparative Example 1. In Example 2, no pinholes are recognized and the pinhole generation rate is 0%.

Example 2 has the largest percentage of the large-sized polycrystalline silicon chunks S included in all polycrystalline silicon chunks S filled in the crucible 1, and Example 1 has the second largest percentage of the large-sized polycrystalline silicon chunks S. Comparative Example 1 has the smallest percentage of the large-sized polycrystalline silicon chunks S included in all the polycrystalline silicon chunks S filled in the crucible 1. Namely, Example 2 has the smallest ratio (surface-area to weight ratio) of the total surface area of the filled polycrystalline silicon chunks S in the crucible 1 to the total weight of the polycrystalline silicon chunks S filled in the crucible 1, Example 1 has the second smallest surface-area to weight ratio, and Comparative Example 1 has the largest surface-area to weight ratio. As described above, Fig. 4 clarifies that the more the polycrystalline silicon chunks filled in the crucible 1 during the filling step contain the large-sized polycrystalline silicon chunks, the lower the pinhole generation rate becomes.

As described above, in the method for producing an ingot according to the present embodiment, the size of the polycrystalline silicon chunks S to be filled into the crucible 1 is large, and by the method for filling according to the present embodiment, the ratio of the total surface area of the polycrystalline silicon chunks S to be filled to the total weight of the polycrystalline silicon chunks S to be filled into the crucible 1, can be made smaller. For this reason, it is possible to drastically restrict the number of the pinholes formed in the produced ingot in comparison with the conventional art, and to substantially prevent them.

By increasing the size of the polycrystalline silicon chunks S to be filled into the crucible 1, the method for producing an ingot of the present embodiment makes it possible for the polycrystalline silicon chunks S to be randomly supplied into the crucible 1 during the step of filling. Thus, a simple, uncomplicated step of filling can be achieved. For this reason, a method for producing an ingot that is simple and uncomplicated in comparison with the conventional art can be achieved, and the production costs can be reduced.

It should be noted that the present invention is not limited to the above embodiment. Rather, the above embodiment and examples are examples included in the present invention. For example, the distribution of the sizes of the polycrystalline silicon chunks S as the raw materials filled in the crucible 1 is not limited to the above one. Further, the method for producing an ingot is not limited to the above method and can be applied to the MCZ method using a magnetic field and materials other than silicon.

## Claims

1. A method for producing a silicon single crystal ingot, comprising a filling step of filling a crucible with polycrystalline silicon, a melting step of melting the filled polycrystalline silicon to form a silicon melt in the crucible, and a pulling up step of bringing a seed crystal into contact with the silicon melt and pulling up the seed crystal brought into contact, to thereby grow an ingot,
wherein, in the filling step, the crucible is filled with the polycrystalline silicon by a plurality of chunks of polycrystalline silicon being randomly supplied to the crucible, and the chunks of polycrystalline silicon are large-sized chunks of polycrystalline silicon.

2. A method for producing a silicon single crystal ingot according to Claim 1, wherein the large-sized chunks of polycrystalline silicon consist of chunks of polycrystalline silicon with a size of at least 20 mm, and the large-sized chunks of polycrystalline silicon include chunks of polycrystalline silicon of at least one of the types of chunks of polycrystalline silicon with a size of more than 50 mm and chunks of polycrystalline silicon with a size of 20 mm to 50mm.

3. A method for producing a silicon single crystal ingot according to Claim 2, wherein the supplied chunks of polycrystalline silicon include at least the chunks of polycrystalline silicon with a size of more than 50 mm.

4. A method for producing a silicon single crystal ingot according to Claim 2, wherein the supplied chunks of polycrystalline silicon include at least the chunks of polycrystalline silicon with a size of 20 mm to 50 mm.

5. A method for producing a silicon single crystal ingot according to Claim 2, wherein the large-sized chunks of polycrystalline silicon consist of the chunks of polycrystalline silicon with a size of more than 50 mm and the chunks of polycrystalline silicon with a size of 20 mm to 50 mm, and the content ratio of the chunks of polycrystalline silicon with a size of more than 50 mm is 70 % by weight, while the content ratio of the chunks of polycrystalline silicon with a size of 20 mm to 50 mm is 30 % by weight.
